# EUROPEAN PATENT APPLICATION

(11) **EP 2 043 258 A1**
(43) Date of publication of application: **01.04.2009**
(21) Application number: 07117517.8
(22) Date of filing: 28.09.2007
(51) Int. Cl.: H03F 3/217, H03F 1/02, H03F 3/24, H04L 27/36

(54) **A method for signal amplification, a switched mode amplifier system, a base station and a communication network therefor**

(71) Applicant: Alcatel-Lucent Deutschland AG, 70435 Stuttgart (DE)
(72) Inventor: Gunreben, Peter, 91096 Moehrendorf (DE); Schenkel, Horst, 90542 Eckental (DE)
(74) Representative: Brose, Gerhard

(57) **Abstract**

The invention concerns a method for signal amplification using a switched mode amplifier system comprising a delta sigma modulator (DSM) and a power amplifier (PA), whereby an XOR operation is performed with the first operand being the output signal of the delta sigma modulator (DSM) and the second operand being a clock signal which has a clock rate N*f_{D} which is a multiple of the clock rate f_{D} of the delta sigma modulator (DSM), and a signal resulting after said XOR operation is used to drive the power amplifier (PA), a switched mode amplifier system, a base station, a mobile station and a communication network therefor.

## Description

The invention relates to a method for signal amplification according to the preamble of claim 1, a switched mode amplifier system according to the preamble of claim 4, a base station according to the preamble of claim 6, a mobile station according to the preamble of claim 7, and a communication network according to the preamble of claim 8.

Mobile communication systems like e.g. Universal Mobile Telecommunications System (UMTS) or Third Generation Partnership Project Long Term Evolution (3GPP LTE) require power amplifiers with high output power at frequencies up to 2.6 GHz.

Using conventional so-called A/AB or C class amplifiers, Lateral Diffused Metal Oxide Silicon (LDMOS) transistor technology meets said requirements of modern radio frequency (RF) power amplifiers.

Another requirement, for REF power amplifiers requests an impedance of 50 Ohm at the input and the output of the power amplifier in the targeted frequency band. As the input and output impedance of LDMOS power transistors is very low, matching circuits at the input and the output of the transistor are required to transform the transistors input and output impedance to the required input and output impedance of 50 Ohm.

Unfortunately, efficient matching structures are bound to specific frequency ranges. Due to the very low impedance of LDMOS power transistors, the supportable frequency range of efficient matching circuits is very small. However, modern power amplifiers need to support a wide range of carrier frequencies, thus, the matching structures for LDMOS power transistors would need to be reconfigurable to support the required range of carrier frequencies.

An alternative to LDMOS transistors are power amplifiers based on galliumnitride (GaN) technology. The input and output impedance of GaN power transistors is inherently much larger than the impedance of LDMOS transistors. Thus, the supportable frequency range of particular matching circuits is also much larger and a reconfiguration of the matching structures may not be needed. Another advantage of GaN transistors is the higher operation voltage, which reduces the currents in the amplifier circuit.

The most important disadvantage of conventional A/AB or C class amplifiers is the low power efficiency. Due to the low power efficiency of the power amplifier, the energy consumption of the base stations is very high and causes high operation expenditures for the operators.

In the communication industry there is always a pressure to reduce costs, especially operation expenditures (OPEX) to be competitive. Therefore the industry is permanently searching for possibilities to reduce the cost of the goods sold. One means to reduce the costs is to increase the efficiency of the analogue hardware by changing the RF power amplifier architecture.

As an alternative to the currently used linear operation mode of e.g. A/AB or C class amplifiers, a new architecture may use so-called D/E/F/S class amplifiers to improve the power efficiency. This new approach inherently leads to higher efficiency of the power amplifier of theoretically 100% and by means of the digital approach reduces analog imperfections and liability.

In said D/E/F/S class switched mode REF power amplifiers, the transistor is not amplifying the inputs signal linearly, but is acting as a switch in the ideal case. As an ideal switch does not dissipate power, a theoretical power efficiency of 100% could be reachable.

In the US patent application US 11/327,838, the use of a class SURF power-amplifier system comprising a delta sigma modulator and a switch mode power amplifier in a radio frequency transmitter is described. This document is regarded as the closest prior art for the invention.

The challenge of D/E/F/S class REF power amplifiers is the generation of the switching signal for the power transistor. The well known delta sigma modulator can be used for generating the switching signal and can be implemented in a digital circuitry, Using conventional delta sigma modulator, the supportable carrier frequency strongly depends on the maximum clock rate supported by the digital circuit. For a conventional delta sigma modulator, the digital circuitry needs to generate the switching signal at a clock rate of at least double the carrier frequency, e.g. the digital circuit would need to run at a clock rate above 4 GHz to generate a 2 GHz signal.

The maximum clock rate of field programmable gate arrays (FPGAs) is about 600MHz, currently. Thus, the conventional delta sigma modulator implemented in field programmable gate arrays cannot generate carrier frequencies above 300 MHz.

As complex circuits like field programmable gate arrays for implementing a delta sigma modulator are currently not available at the required high clock rates, the switching signal can alternatively be generated at a lower sampling rate, and one of the spectral copies of the discrete time signal at higher frequencies may represent the desired signal used for switching.

When converting the digital time-discrete signal into a continuous time signal using sample-and-hold output of a delta sigma modulator, spectral copies are available in the continuous time signal, but the resulting spectrum is attenuated by a sin(x)/x function. Thus, signals with higher frequencies show lower amplitudes, and the maximum power of the desired signal will be very limited, which reduces the power efficiency of the power amplifier."

The object of the invention is thus to propose, a method to overcome the inherent attenuation of signals towards higher frequencies in order to increase the efficiency of the power amplifier.

This object is achieved by a method according to the teaching of claim 1, a switched mode amplifier system according to the teaching of claim 4, a base station according to the teaching of claim 6, a mobile station according to the teaching of claim 7, and a communication network according to the teaching of claim 8.

The main idea of the invention is to combine the output signal of a delta sigma modulator with a clock signal which has a clock rate which is a multiple of the clock rate of the delta sigma modulator by means of an exclusive OR (XOR) operation. Said XOR operation is equivalent to an upconversion by half of the sampling frequency, which leads to a strongly increased amplitude of the desired signal and reduced amplitudes of all other unused spectral copies if the appropriate sampling frequency, i.e. clock rate of the clock signal, is chosen.

Further developments of the invention can be gathered from the dependent claims and the following description.

In the following the invention will be explained further making reference to the attached drawings.

Fig. 1 schematically shows a switched mode amplifier system according to the state-of-the-art.

Fig. 2 schematically shows a switched mode amplifier system with digital upconversion according to the invention.

Fig. 3 shows on the left side the spectrum of a time-discrete digital signal and on the right side the corresponding spectrum of a continuous time signal resulting from sample-and-hold operation of the time-discrete digital signal.

Fig. 4 shows the continuous time signal after an XOR operation.

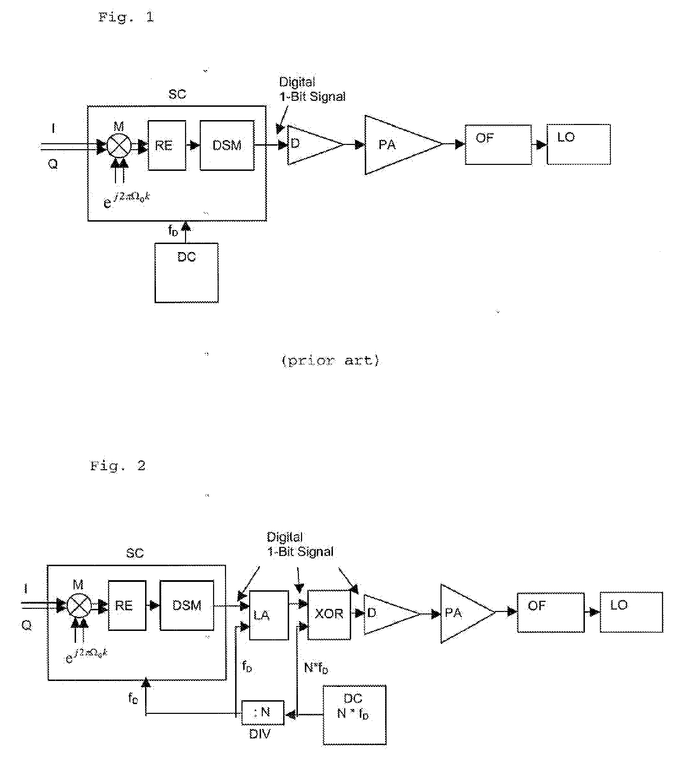

A switched mode amplifier system according to the state-of-the-art as shown in fig. 1 comprises a modulator M with inputs for reception of so-called I and Q signals. The outputs of the modulator M are connected to inputs of a module RE for determination of the real part of a signal. The output of the module RE is in turn connected to the input of a delta sigma modulator DSM.

The modulator M, the module RE and the delta sigma modulator DSM build together a signal converter SC.

The output of the delta sigma modulator DSM is connected to the input of a driver D for driving a power amplifier. The out-punt of the driver D is connected to the input of a switched mode power amplifier PA. The output of the switched mode power amplifier PA is connected to the input of an output filter OF. Finally the output of the output filter OF is connected to a 50 Ohm load LO.

The signal converter SC additionally is connected to a digital clock DC.

In a method for power amplification using a switched mode amplifier system according to the state-of-the-art as shown in fig. 1, I and Q signals are sent to the modulator M. In said modulator M, the I and Q signals are modulated with a carrier frequency Q, and the modulated I and Q signals are sent to the module RE.

In the module RE, the real parts of the modulated I and Q signals are determined and sent to the delta sigma modulator DSM.

In the delta sigma modulator DSM, the time-discrete input signal is converted into a continuous time signal using a so-called sample-and-hold output. The sampling rate is determined by the clock rate of the digital clock DC. At the output of the delta sigma modulator DSM, a digital 1-bit signal is provided.

Said digital 1-bit signal is sent to the driver D that generates a driver signal based on the digital 1-bit signal and sends the driver signal to the switched mode power amplifier PA.

In the switched mode power amplifier PA, the driver signal is amplified resulting in an amplifier signal that is sent via the output filter OF to the 50 Ohm load LO.

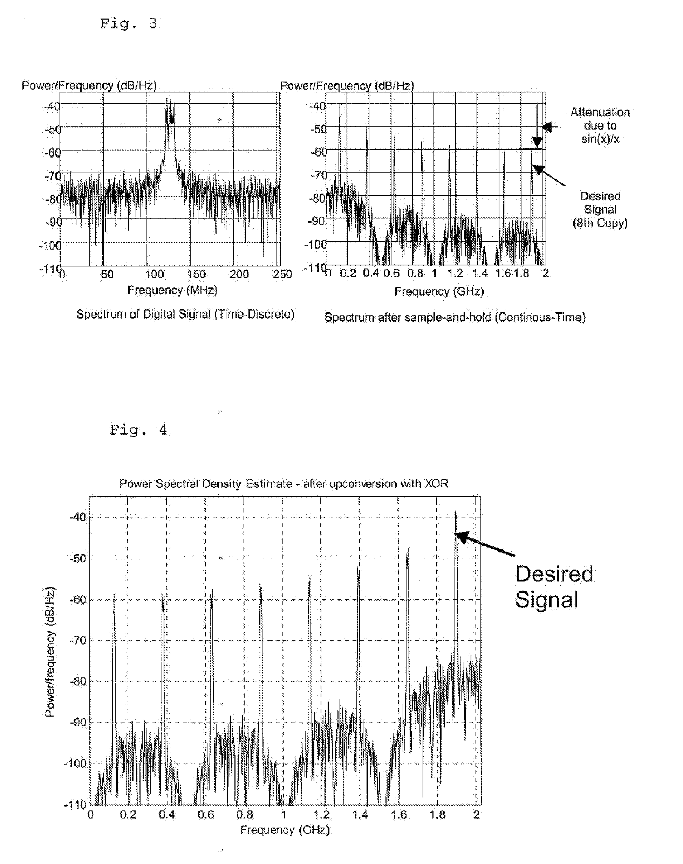

The left diagram in fig. 3 shows the power spectral density, i.e. the power per frequency in dB per Hz depicted over the frequency in MHz, for an example of a spectrum of a time-discrete digital signal sampled at about 500*10⁶ samples/sec. The maximum of the time-discrete digital signal is at about 130 MHz.

The right diagram in fig. 3 shows the power spectral density, i.e. the power per frequency in dB per Hz depicted over the frequency in GHz, for the corresponding spectrum of a continuous time signal resulting from sample-and-hold operation of the time-discrete digital signal as depicted in the left diagram.

Such a sample-and-hold operation is performed in the delta sigma modulator DSM, and the spectrum in the right diagram in fig. 3 corresponds to the signal at the output of the delta sigma modulator DSM. However, the spectrum in the right diagram in fig. 3 is qualitatively not representative for operation of the delta sigma modulator DSM, but shall illustrate the functionality of the delta sigma modulator DSM.

Due to the sample-and-hold conversion of the time-discrete digital signal into a continuous time signal, spectral copies are available in the continuous time signal, and the magnitude of the spectrum is inherently shaped with a sin(x)/x function, thus inserting more and more attenuation towards higher frequencies. At the 8^{th} spectral copy at about 1.9 GHz, which is the desired signal in this example, we observe about 20dB attenuation compared to the baseband signal at about 125 MHz.

As can be seen from fig. 3, it is possible to generate high carrier frequencies of e.g. 1.9 GHz at lower clock rates of e.g. about 500*10⁶ Samples/sec of the digital circuit, but the desired signal will have a small power spectral density. Due to the high attenuation of the desired signal, the achievable power efficiency of the switched mode amplifier system will be strongly limited.

According to the invention, in order to overcome the inherent attenuation towards higher frequencies, it is proposed to combine the output signal of a delta stigma modulator DSM with a clock signal which has a clock rate which is a multiple of the clock rate of the delta sigma modulator by means of an exclusive OR (XOR) operation.

A respective switched mode amplifier system according to the invention is shown in fig. 2.

Said switched mode amplifier system comprises a modulator M with inputs for reception of so-called I and Q signals. The outputs of the modulator M are connected to inputs of a module RE for determination of the real part of a signal. The output of the module RE is in turn connected to the input of a delta sigma modulator DSM.

The modulator M, the module RE and the delta sigma modulator DSM build together a signal converter SC.

The output of the delta sigma modulator DSM is connected to an input of a latch LA, and the output of the latch LA is connected to a first input of an exclusive OR gate XOR.

A digital clock DC is connected to the input of divider DIV and to a second input of the exclusive OR gate XOR.

The output of the divider DIV is connected to a further input of the latch LA and to the signal converter SC.

The output of the exclusive OR gate XOR is connected to the input of a driver D for driving a power amplifier. The output of the driver D is connected to the input of a switched mode power amplifier PA. The output of the switched mode power amplifier PA is connected to the input of an output filter OF. Finally the output of the output filter OF is connected to a 50 Ohm load LO.

In a method for power amplification using a switched mode amplifier system according to the invention as shown in fig. 2, I and Q signals are sent to the modulator M. In said modulator M, the I and Q signals are modulated with a carrier frequency Ω₀, and the modulated I and Q signals are sent to the module RE.

In the module RE, the real parts of the modulated I and Q signals are determined and sent to the delta sigma modulator DSM.

In the delta sigma modulator DSM, the time-discrete input signal is converted into a continuous time signal using a so-called sample-and-hold output. The sampling rate is determined by the clock rate f_{D} of a clock signal received from the divider DIV. At the output of the delta sigma modulator DSM, a digital 1-bit signal is provided.

Said digital 1-bit signal is sent to the input of the latch LA. In the latch LA the digital 1-bit signal is synchronized with the clock rate f_{D} of a clock signal received from the divider DIV resulting in a synchronized digital 1-bit signal.

Said synchronized digital 1-bit signal is sent to the first input of the exclusive OR gate XOR. In said exclusive OR gate XOR, the synchronized digital 1-bit signal is combined by means of an exclusive OR operation with a clock signal which has a clock rate N*f_{D} which is N times the clock rate f_{D} of the delta sigma modulator DSM and which has been sent from the digital clock DC.

In the example depicted in fig. 2, a digital clock DC generating a clock rate N*f_{D} which is N times the clock rate of the clock rate f_{D} of the delta sigma modulator DSM is used. The clock rate f_{D} of the delta sigma modulator DSM and of the latch LA is derived by dividing the clock rate N*f_{D} generated by the digital clock DC by N.

In another embodiment of the invention, the high clock rate N*f_{D} used for the clock signal of the exclusive OR gate XOR can also be synthesized using a so-called phase locked loop (PLL) oscillator based on the clock rate f_{D} of a clock of the delta sigma modulator DSM.

As the output bits of the delta sigma modulator DSM represent a digital signal with the values +1 and -1, the exclusive OR operation represents a multiplication with an alternating sequence of +1 and -1 values. From a digital signal processing point of view, the alternating sequence of +1 and -1 values represents a signal of magnitude 1 and frequency Q=π. Thus, the multiplication with said signal, i.e. the exclusive OR operation, is equivalent to an upconversion by half of the sampling frequency N*f_{D} of the exclusive OR gate XOR resulting in an upconverted digital 1-bit signal at the output of the exclusive OR gate XOR.

Said upconverted digital 1-bit signal is sent to the driver D that generate a driver signal based on the digital 1-bit signal and sends the driver signal to the switched mode power amplifier PA.

in the switched mode power amplifier PA, the driver signal is amplified resulting in an amplifier signal that is sent via the output filter OF to the 50 Ohm load LO.

The spectrum in the diagram in fig. 4 corresponds to the upconverted digital 1-bit signal at the output of the exclusive OR gate XOR as described above.

The spectrum in fig. 4 corresponds to an upconversion of the baseband signal at about 125 MHz as depicted in the right diagram in fig. 3 to the desired signal at about 1.9 GHz by means of applying a clock rate N*f_{D} of 7*500 MHz = 3.5 GHz for the exclusive OR operation in the exclusive OR gate XOR.

By means of choosing the appropriate values for the clock rate f_{D} of the delta sigma modulator DSM and for the clock rate N*f_{D} of the exclusive OR gate XOR, a desired signal at a desired frequency can be achieved.

It can be easily seen that the upconversion using an exclusive OR operation according to the invention strongly increases the power spectral density of the desired signal and that the amplitude of all other unused spectral copies is reduced. The benefit of the unconverted spectrum as depicted in fig. 4 is twofold:
1) The magnitude of the desired signal is increased, which improves the power efficiency.
2) The magnitude of undesired signals is reduced, thus also power dissipation caused by unwanted signal components is reduced.

Such a switched mode amplifier system according to the invention as described above can be comprised in a transmitter used for transmission in a base station or a mobile station that are part of a communication network.

In conclusion, the invention enables the efficient generation of digital driver signals for switched mode amplifiers for high carrier frequencies with at the same time relaxed clock rate requirements of the delta sigma modulator DSM, which is essential for a change of the RF power amplifier architecture from linear operation condition with so-called class A/AB/B amplifiers to switched mode operation condition with so-called class D/E/F/S amplifiers. Said switched mode operation has the advantage of dramatically increased power efficiency. The proposed upconversion involves only very simple digital components like latch and exclusive OR gate, which are available at very high clock rates.

## Claims

1. A method for signal amplification using a switched mode amplifier system comprising a delta sigma modulator (DSM) and a power amplifier (PA), **characterized in, that**
• an XOR operation is performed with the first operand being the output signal of the delta sigma modulator (DSM) and the second operand being a clock signal which has a clock rate N*f_{D} which is a multiple of the clock rate f_{D} of the delta sigma modulator (DSM),
* and a signal resulting after said XOR operation is used to drive the power amplifier (PA).

2. A method according to claim 1, **characterized in, that** the clock rate f_{D} of the delta sigma modulator (DSM) is derived by dividing the clock rate N*f_{D} of a clock generator signal by N by means of a divider (DIV).

3. A method according to claim 1, **characterized in, that** said clock signal which has a clock rate N*f_{D} which is a multiple of the clock rate f_{D} of the delta sigma modulator (DSM) is synthesized using a phase locked loop oscillator based on the clock of the delta sigma modulator (DSM).

4. A switched mode amplifier system comprising a delta sigma modulator (DSM) and a power amplifier (PA), **characterized in, that**
• said switched mode amplifier system comprises at least one processing means (XOR) adapted to perform an XOR operation with the first operand being the output signal of the delta sigma modulator (DSM) and the second operand being a clock signal which has a clock rate N*f_{D} which is a multiple of the clock rate f_{D} of the delta sigma modulator (DSM),
• and said at least one processing means (XOR) is adapted to send a signal via its output which is resulting from said XOR operation and which is used to drive the power amplifier (PA).

5. A switched mode amplifier system according to claim 4, **characterized in, that** the switched mode amplifier system comprises transistors based on GaN technology.

6. A base station comprising at least one switched mode amplifier system comprising a delta sigma modulator (DSM) and a power amplifier (PA) , **characterized in, that**
• said switched mode amplifier system comprises at least one processing means (XOR) adapted to perform an XOR operation with the first operand being the output signal of the delta sigma modulator (DSM) and the second operand being a clock signal which has a clock rate N*f_{D} which is a multiple of the clock rate f_{D} of the delta sigma modulator (DSM),
• and said at least one processing means (XOR) is adapted to send a signal via its output which is resulting from said XOR operation and which is used to drive the power amplifier (PA).

7. A mobile station comprising at least one switched mode amplifier system comprising a delta sigma modulator (DSM) and a power amplifier (PA) , **characterized in, that**
• said switched mode amplifier system comprises at least one processing means (XOR) adapted to perform an XOR operation with the first operand being the output signal of the delta sigma modulator (DSM) and the second operand being a clock signal which has a clock rate N*f_{D} which is a multiple of the clock rate f_{D} of the delta sigma modulator (DSM),
• and said at least one processing means (XOR) is adapted to send a signal via its output which is resulting from said XOR operation and which is used to drive the power amplifier (PA).

8. A communication network with at least one base station or mobile station comprising at least one switched mode amplifier system comprising a delta sigma modulator (DSM) and a power amplifier (PA), **characterized in, that**
• said switched mode amplifier system comprises at least one processing means (XO^{R}) adapted to perform an XOR operation with the first operand being the output signal of the delta sigma modulator (DSM) and the second operand being a clock signal which has a clock rate N*f_{D} which is a multiple of the clock rate f_{D} of the delta sigma modulator (DSM),
• and said at least one processing means (XOR) is adapted to send a signal via its output which is resulting from said XOR operation and which is used to drive the power amplifier (PA).
